(19) Europäisches Patentamt
European Patent Office
Office européen des brevets

(11) **EP 3 735 644 B1**

(12) **FASCICULE DE BREVET EUROPEEN**

(45) Date de publication et mention
de la délivrance du brevet:
**05.10.2022 Bulletin 2022/40**

(21) Numéro de dépôt: **19703143.8**

(22) Date de dépôt: **04.01.2019**

(51) Classification Internationale des Brevets (IPC):
*G06F 17/15* (2006.01)    *F02C 9/58* (2006.01)
*G01P 3/46* (2006.01)    *G05B 11/01* (2006.01)
*G05B 19/416* (2006.01)    *H03H 21/00* (2006.01)

(52) Classification Coopérative des Brevets (CPC):
**G06F 17/15; F02C 9/58; G01P 3/46; G01P 21/02;**
**H03H 21/0012;** F05D 2270/304

(86) Numéro de dépôt international:
**PCT/FR2019/050010**

(87) Numéro de publication internationale:
**WO 2019/135053 (11.07.2019 Gazette 2019/28)**

(54) **PROCÉDÉ DE FILTRAGE ADAPTATIF**

ADAPTIVES FILTERVERFAHREN

ADAPTIVE FILTERING METHOD

(84) Etats contractants désignés:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorité: **04.01.2018 FR 1850032**

(43) Date de publication de la demande:
**11.11.2020 Bulletin 2020/46**

(73) Titulaire: **SAFRAN AIRCRAFT ENGINES**
**75015 Paris (FR)**

(72) Inventeur: **DJELASSI, Cedrik**
**77550 Moissy-Cramayel Cedex (FR)**

(74) Mandataire: **Regimbeau**
**20, rue de Chazelles**
**75847 Paris Cedex 17 (FR)**

(56) Documents cités:
**WO-A1-2014/053752    WO-A1-2015/019003**
**FR-A1- 2 842 901**

• **GELFAND SAUL B ET AL: "A**
**TREE-STRUCTURED PIECEWISE LINEAR**
**ADAPTIVE FILTER", IEEE TRANSACTIONS ON**
**INFORMATION THEORY, IEEE PRESS, USA, vol.**
**39, no. 6, novembre 1993 (1993-11), pages**
**1907-1922, XP000433059, ISSN: 0018-9448, DOI:**
**10.1109/18.265499**

## Description

### Domaine de l'invention

L'invention concerne un dispositif de filtrage d'un signal mesuré relatif à une grandeur d'une turbomachine, typiquement la vitesse angulaire d'un arbre moteur d'une turbomachine, afin de produire un signal de base, typiquement le signal dérivé du signal de vitesse, destiné à être utilisé dans un système de régulation de la turbomachine.

L'invention concerne également une turbomachine dont le système de régulation contient un tel dispositif de filtrage.

### Présentation de l'Art Antérieur

Dans la régulation d'un paramètre d'un système, il est habituel d'établir la dérivée du signal de cette grandeur pour l'utiliser dans une boucle de contre-rétroaction.

Par exemple, dans un turboréacteur double corps double flux, il est important de contrôler au moins une vitesse angulaire d'un arbre moteur d'un des deux corps. Il est généralement prévu de contrôler la vitesse de rotation N2 (en rpm ou tour par minute) du corps haute-pression, voire également la vitesse de rotation N1 (en rpm ou tour par minute) du corps basse-pression. Le contrôle peut s'effectuer en utilisant un capteur de vitesse angulaire, qui produit un signal dont l'amplitude est généralement fonction de la valeur de la vitesse et que l'on dérive avant de l'injecter dans la boucle de contre-rétroaction du système de régulation.

Il est possible que du bruit perturbe le signal de la grandeur à contrôler ou bien son signal dérivé, en particulier dans des cas où l'amplitude du signal est particulièrement faible par rapport aux amplitudes les plus grandes que peut présenter le signal. Cela diminue les performances du système de régulation, puisque l'utilisation par le système de régulation de ce signal ou de son signal dérivé d'amplitude inférieure au bruit correspondant devient problématique.

Le bruit peut en particulier provenir de la numérisation du signal. Le signal est transformé en une série temporelle de valeurs mesurées, un pas d'échantillonnage en temps $\Delta t$ séparant temporellement deux valeurs mesurées successives. Un pas de quantification ou résolution numérique donne la différence minimale entre deux valeurs mesurées différentes. La dégradation que subit le signal lors d'une telle conversion analogique numérique est analogue à celle que produirait un bruit superposé au signal. Ce bruit est appelé bruit de quantification ou bruit d'échantillonnage. Dans ce texte, un signal numérisé désigne un signal transformé par conversion analogique numérique avec un pas d'échantillonnage et un pas de quantification et qui présente un bruit de quantification.

Concrètement, à cause de ce bruit, on peut observer entre deux pas d'échantillonnage consécutifs une variation d'au moins un pas de quantification sur le signal numérisé, alors que la valeur réelle de la grandeur physique est stable.

Par exemple un bruit d'échantillonnage (aussi appelé bruit de quantification) peut apparaître si les signaux mesurés des grandeurs N1 et N2 sont numérisés au cours du temps. Pour le signal N2 la numérisation s'effectue classiquement avec un pas d'échantillonnage en temps $\Delta t$ égal à 30 ms = 0,03s et un pas de quantification (résolution numérique) en vitesse angulaire $\Delta N$ égal à 1rpm = 1 tour par minute. La dérivée numérique de ce signal, correspondant à l'accélération angulaire dN2/dt, est numérisée avec un pas minimum entre deux valeurs consécutives égal au rapport de $\Delta N/\Delta t$. Classiquement pour le signal dN2/dt, ce rapport est donc supérieur à 30 rpm/s, et par conséquent une consigne d'accélération angulaire inférieure à 20 rpm/s ne peut pas être correctement mesurée ni suivie par le système.

D'une manière générale, l'utilisation d'une dérivée numérique d'un signal numérisé par un système de régulation fait naître des limites dans la précision des consignes d'accélérations. Cet obstacle peut être associé en et au contrôle du turboréacteur en accélération de régime dans lesquels la régulation d'une grandeur de turbomachine peut nécessiter la dérivée numérique du signal numérisé relatif à cette grandeur.

Il existe d'autres exemples de paramètres mesurés d'une turbomachine dont les amplitudes varient dans une très large plage, et dont la numérisation peut entraîner par conséquent un bruit d'échantillonnage en particulier pour les signaux de relativement faible amplitude. Comme exemples de tels paramètres on peut citer la pression ou la dérivée de la pression mesurée dans une zone de la turbomachine, par exemple en entrée ou en sortie d'un compresseur du corps basse-pression ou du corps haute-pression.

La solution classique visant à pallier le problème de bruit consiste à filtrer les signaux avant leur injection dans la boucle de rétroaction du système de régulation. Le filtre réduit le bruit mais il agit également sur la dynamique temporelle du signal filtré comparé au signal avant filtrage. Les performances du système de régulation en sont impactées. WO2014/053752 divulgue une méthode de surveillance d'un défaut de poussée d'un turboréacteur.

### Présentation de l'invention

Un but général de l'invention est de pallier les inconvénients des systèmes de régulation de l'état de la technique.

Notamment, un but de l'invention est de proposer une solution permettant à la fois un filtrage efficace et une absence de dégradation de la dynamique du système de régulation.

Il est notamment proposé un procédé de filtrage d'un signal d'entrée relatif à une grandeur physique d'une turbomachine, le signal d'entrée étant numérisé, le procédé mettant en oeuvre dans un calculateur d'un système de régulation de ladite turbomachine un filtrage fréquentiel dudit signal, ledit signal étant fourni à l'entrée du calculateur,
caractérisé en ce que l'on met en oeuvre

- une détection sur ledit signal d'entrée d'une variation d'amplitude de ladite grandeur,
- une adaptation du filtrage fréquentiel dudit signal d'entrée en fonction de la variation d'amplitude détectée de ladite grandeur.

La grandeur que l'on souhaite utiliser pour la régulation de la turbomachine peut présenter différents niveaux d'amplitudes caractéristiques très différentes, par exemple différents régimes d'un arbre moteur allant du ralenti jusqu'à la pleine accélération et pour lesquels le signal représentatif du régime moteur balaye une amplitude très importante.

Comme le signal d'entrée est numérisé, il est issu d'une transformation par conversion analogique numérique avec un pas d'échantillonnage et un pas de quantification et présente un bruit de quantification.

L'effet du bruit sur la mesure du signal peut alors être différent d'un niveau d'amplitude à un autre, par exemple d'un régime à l'autre, de même que le besoin en termes de filtrage n'est pas le même d'un régime à l'autre.

En utilisant le procédé proposé, il est possible de satisfaire à des besoins en filtrage du signal d'entrée d'une grandeur utilisée pour la régulation de la turbomachine, par exemple la vitesse de l'arbre moteur, différents selon le régime ou de manière générale selon l'amplitude balayée par ladite grandeur, et d'assurer de meilleures performances du système de régulation par rapport à un système de régulation qui mettrait en oeuvre un même filtrage quelle que soit l'amplitude balayée par ladite grandeur.

Le procédé est avantageusement complété par les étapes suivantes :

- la génération d'un signal de dérivée seconde du signal d'entrée,
- la comparaison d'une valeur du signal de dérivée seconde du signal d'entrée avec au moins un seuil prédéterminé,
- le contrôle d'un filtre contrôlé, apte à appliquer un filtrage fréquentiel au signal d'entrée, de sorte que le filtre applique ou non le filtrage fréquentiel en fonction d'un résultat de la comparaison.

Selon un mode possible de mise en oeuvre, le signal d'entrée traverse un filtre distinct du filtre contrôlé de sorte qu'un filtrage fréquentiel du signal d'entrée est réalisé par le filtre distinct du filtre contrôlé quel que soit le résultat de l'étape de comparaison, le filtre distinct du filtre contrôlé étant agencé soit en amont soit en aval du filtre contrôlé.

Selon un aspect de l'invention, on génère et on utilise la valeur de la dérivée seconde du signal représentatif de la grandeur mesurée pour caractériser les transitions de régime ou d'amplitudes balayées par cette grandeur utilisée pour la régulation de la turbomachine. Il est possible de comparer cette valeur de dérivée seconde à un nombre arbitrairement élevé de seuils et de définir autant de configurations de filtrage en correspondance. Cela permet d'adapter le filtrage fréquentiel en autant de configurations de filtrage différentes que souhaité.

Selon un mode possible de mise en oeuvre, le procédé peut comprendre en outre des étapes de :

- comparaison d'une valeur du signal de dérivée seconde du signal d'entrée avec plusieurs seuils prédéterminés,
- contrôle de plusieurs filtres contrôlés, chacun apte à appliquer un filtrage fréquentiel au signal d'entrée, de sorte que le filtre contrôlé applique ou non le filtrage fréquentiel en fonction d'un résultat de la comparaison à un des seuils.

Avantageusement, le procédé peut être configuré de sorte que:

- chaque filtre contrôlé est apte à appliquer un filtrage fréquentiel de type passe-bas, chaque filtre contrôlé étant associé à un seuil prédéterminé;
- le contrôle d'un filtre contrôlé est configuré de sorte que le filtre contrôlé n'applique pas le filtrage fréquentiel si une valeur du signal de dérivée seconde du signal d'entrée est supérieure à son seuil prédéterminé associé ;

Ce mode de mise en oeuvre de l'invention apporte une solution dans le contrôle de la vitesse angulaire N2 du corps haute-pression d'une turbomachine, lorsque son signal est perturbé par un bruit d'échantillonnage. On utilise classiquement pour s'affranchir du bruit d'échantillonnage un filtre passe-bas, comme par exemple une « moyenne glissante » qui consiste à remplacer la dernière valeur du signal par une moyenne de cette valeur et de « n » valeurs précédentes. L'effet sur la dynamique du signal filtré est la génération d'un retard avec le signal réel : une variation dans le signal réel apparaît plus tard dans le signal filtré. Ce retard, dans le cas particulier des « moyennes glissantes », augmente si on augmente le nombre « n » ou si on effectue plusieurs fois successivement l'étape de « moyennes glissantes ». Un système régulé qui utilise un tel filtre, peut donc réagir à une variation du signal réel avec un retard.

En outre, dans le cas du signal dN2/dt dans les turboréacteurs double corps double flux, on peut distinguer deux régimes opposés, où les caractéristiques du signal apte à réguler correctement le système sont différentes.

- La première zone correspond à un régime stable (typiquement la phase de croisière d'un avion) : le signal réel dN2/dt est centré sur zéro et présente peu de variations rapides. Le bruit d'échantillonnage qui entache le signal numérisé dN2/dt produit un rapport signal sur bruit faible, ce qui exige de filtrer suffisamment le signal réel pour augmenter ce rapport signal sur bruit. De plus, comme le régime est stable, il n'est pas nécessaire que le retard du signal de contrôle sur le signal réel soit faible. On peut donc utiliser un signal très filtré pour cette première zone de fonctionnement sans que le retard généré diminue les performances de la régulation.

- La deuxième zone correspond à un régime de variations rapides (typiquement la phase d'approche d'un avion) : le signal réel dN2/dt présente des variations rapides et importantes. Le bruit d'échantillonnage qui entache le signal numérisé dN2/dt laisse un rapport signal sur bruit fort, ce qui laisse la liberté de ne pas filtrer le signal réel. Dans cette zone de fonctionnement, il est nécessaire que le retard du signal de contrôle sur le signal réel soit le plus faible possible. On ne peut donc utiliser qu'un signal non filtré ou peu filtré pour cette seconde zone de fonctionnement.

Dans ce mode de mise en oeuvre de l'invention appliqué au contrôle de la vitesse angulaire N2, plus on est proche d'un régime de variations rapides et plus la valeur d'une dérivée seconde du signal d'entrée est importante.

Cette valeur peut dépasser un seuil prédéterminé, de sorte que le filtre contrôlé n'applique pas le filtrage fréquentiel et le signal filtré a moins de retard sur le signal réel.

A l'inverse, plus on est proche d'un régime stable, plus la valeur d'une dérivée seconde du signal d'entré est faible, plus cette valeur est dépassée (en valeur absolue) par un seuil prédéterminé et plus le rapport signal sur bruit du signal filtré augmente.

Globalement le signal filtré par un tel procédé présente dans tous les régimes de la vitesse de l'arbre moteur un retard suffisamment faible sur le signal réel et un rapport signal sur bruit suffisamment important pour contrôler le système régulé de manière satisfaisante.

Avantageusement, le procédé peut comprendre en outre des étapes de :

- réception par au moins un comparateur à deux entrées et une sortie, sur une première entrée d'un signal de dérivée seconde du signal d'entrée et sur la seconde entrée d'un signal correspondant à un seuil prédéterminé,

- génération par au moins un comparateur d'un signal de comparaison correspondant au résultat de la comparaison entre les signaux reçus sur ses deux entrées,

- réception par au moins un sélecteur de voie à :

  ◦ une première voie d'entrée,
  ◦ une seconde voie d'entrée,
  ◦ une entrée de commande et
  ◦ une sortie,

du signal de comparaison sur son entrée de commande, chaque sélecteur de voie étant associé à un filtre contrôlé apte à appliquer un filtrage fréquentiel,

- réception sur une des premières voies d'entrée d'au moins un sélecteur de voie du signal d'entrée de son filtre contrôlé associé, et sur sa seconde voie d'entrée d'un signal auquel son filtre contrôlé associé a appliqué le filtrage fréquentiel,

- transmission vers la sortie du sélecteur de voie de l'un de ses deux signaux selon la valeur du signal de comparaison.

De plus, l'étape de génération d'un signal de dérivée seconde du signal d'entrée peut comprendre les étapes suivantes :

- génération d'un signal de dérivée première du signal d'entrée par application d'un filtre dérivateur au signal d'entrée,

- génération d'un signal de dérivée première filtré par application d'au moins un filtre fréquentiel de type « passe-bas » à un signal de dérivée première,

- génération d'un signal de dérivée seconde par application d'un filtre dérivateur à un signal de dérivée première filtré.

Le type de filtre passe-bas peut être librement choisi parmi les moyennes sur plusieurs pas, les filtres passe-bas d'ordre 1, 2 ou supérieur, les filtres passe-bas à réponse impulsionnelle finie (filtre FIR), ou infinie (filtre RII).

La grandeur physique de la turbomachine auquel est relatif le signal d'entrée filtré par l'un des procédés de filtrage décrits plus haut, peut être la vitesse angulaire d'un arbre moteur de la turbomachine.

L'invention porte également sur un calculateur d'un système de régulation d'une turbomachine configuré pour mettre en oeuvre des procédés tels qu'on les a décrits dans cette section, ledit calculateur recevant en entrée un signal d'entrée relatif à une grandeur de la turbomachine et générant en sortie un signal de base utilisé dans la régulation de la vitesse angulaire de l'arbre moteur.

L'invention porte en outre sur un ensemble comportant une turbomachine comprenant au moins un arbre moteur et un système de régulation de la vitesse angulaire d'un arbre moteur de la turbomachine, ledit système de régulation comportant un calculateur tel qu'on l'a décrit dans cette section, ledit calculateur recevant en entrée un signal d'entrée relatif à une grandeur de la turbomachine et générant en sortie un signal de base utilisé dans la régulation de la vitesse angulaire de l'arbre, le système de régulation commandant la turbomachine en fonction du signal de mesure filtré ainsi généré par ledit calculateur.

Selon un autre mode possible, le système de régulation utilise une dérivée numérique de la vitesse angulaire de l'arbre moteur pour contrôler la turbomachine en accélération de régime moteur, et le système de régulation est prévu pour fournir des consignes d'accélération angulaire pouvant avoir des valeurs inférieures au rapport d'un pas de quantification sur un pas d'échantillonnage du signal d'entrée numérisé, le signal d'entrée étant une mesure de la vitesse angulaire.

Enfin, l'invention porte également sur un programme d'ordinateur comprenant des instructions adaptées à la mise en oeuvre de chacune de chacune des étapes des procédés tels qu'on les a décrits dans cette section, lorsque ledit programme est exécuté sur un ordinateur. L'invention est définie dans les revendications indépendantes.

**Présentation des figures**

D'autres caractéristiques et avantages de l'invention ressortiront encore de la description qui suit, laquelle est purement illustrative et non limitative, et doit être lue en regard des dessins annexés sur lesquels :

- la Figure 1 représente schématiquement un turboréacteur double corps double flux dont les vitesses de rotation N1 et N2 sont commandés par un système de régulation ;
- la Figure 2 représente un diagramme fonctionnel de filtre numérique adaptatif selon un exemple particulier de mise en oeuvre de l'invention;
- la Figure 3 représente un diagramme fonctionnel d'un mode de réalisation d'un filtre numérique adaptatif selon un exemple particulier de mise en oeuvre de l'invention, et comprenant deux seuils;
- La Figure 4 représente le signal dN2/dt au cours du temps dans un régime stable, au sein d'un système régulé dont le signal de commande fait intervenir le signal dérivé dN2/dt.
- La Figure 5 représente le signal N2 au cours du temps dans un régime de variations rapides, au sein d'un système régulé dont le signal de commande fait intervenir le signal dérivé dN2/dt.

**Description détaillée**

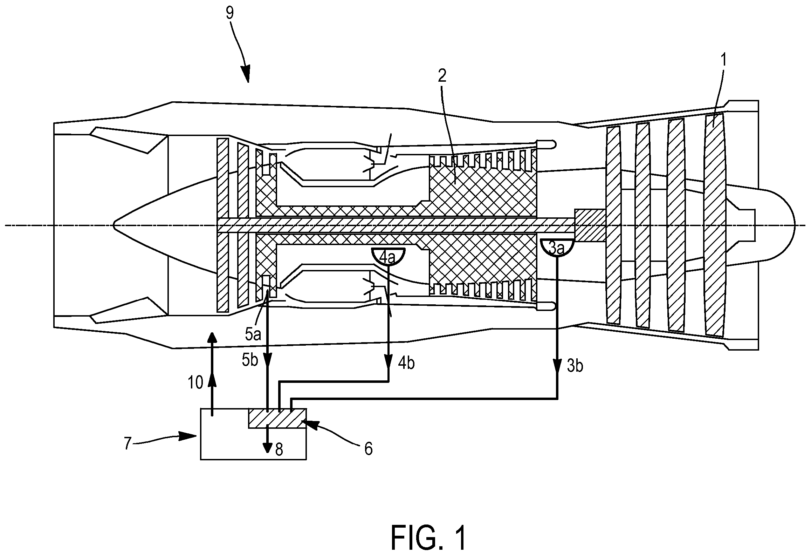

La Figure 1 représente schématiquement un turboréacteur double corps double flux 9 régulé par le système de régulation 7. Au moins une des grandeurs du turboréacteur est mesurée grâce à un capteur : la vitesse de rotation N1 du corps basse pression 1 peut être mesurée par le capteur de vitesse 3a qui produit le signal d'entrée 3b dépendant de N1, la vitesse de rotation N2 du corps haute pression 2 peut être mesurée par le capteur de vitesse 4a qui produit le signal d'entrée 4b dépendant de N2.

D'autres grandeurs peuvent être mesurées, comme par exemple la pression dans une zone du corps haute pression 2 mesurée par une sonde de pression 5a qui produit le signal d'entrée 5b.

Les signaux d'entrée 3b,4b et 5b sont envoyés vers un calculateur 6 qui fait partie du système de régulation 7.

La calculateur 6 délivre un signal de base 8 relatif à l'une des grandeurs dont il a reçu le signal d'entrée, par exemple un signal de vitesse angulaire. Ce signal de base 8 est utilisé dans la régulation du turboréacteur, et dans la production du signal de commande 10 issu du système de régulation délivré à un bloc de commande du turboréacteur.

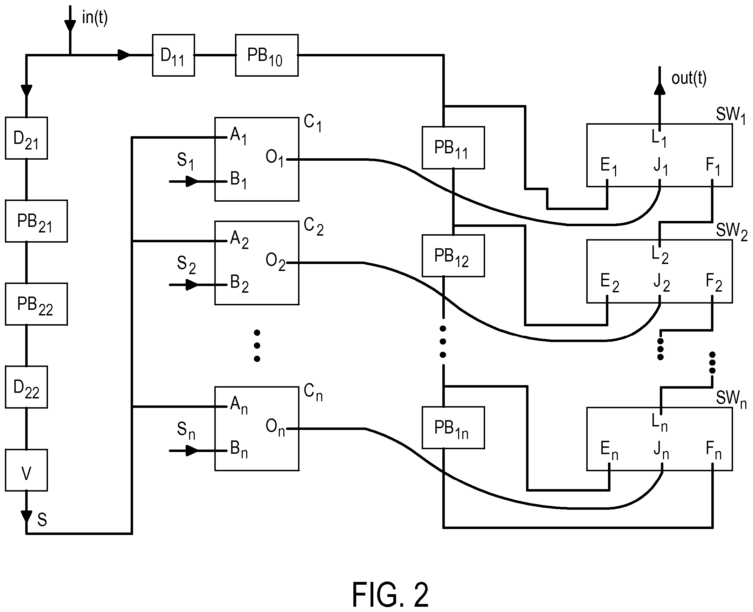

La Figure 2 représente un diagramme fonctionnel de filtre numérique adaptatif selon une mise en oeuvre particulière de l'invention.

Le signal d'entrée du système $in(t)$ est appliqué aux entrées des filtres dérivateurs $D_{11}$ et $D_{21}$, dont la fonction consiste à remplacer la valeur numérisée reçue $in(t)$ par la valeur $\dfrac{in(t)-in(t-\Delta t)}{\Delta t}$ où $\Delta t$ est le pas d'échantillonnage temporel.

Ces filtres numériques utilisent des logiciels de calcul pour déterminer la dérivée numérique du signal d'entrée numérisé.

La sortie du filtre dérivateur $D_{11}$ est connectée à l'ensemble des filtres passe-bas notés $PB_{10}$, $PB_{11}$, $PB_{12}$... $PB_{1n}$, qui sont disposés en série. Chaque filtre passe-bas $PB_{11}$, $PB_{12}$... $PB_{1n}$ est un filtre contrôlé associé à un sélecteur de voie noté $SW_1$, $SW_2$... $SW_n$, et chaque entrée de filtre passe-bas est connectée à la première voie d'entrée $E_1$, $E_2$... $E_n$ de son moyen de contrôle associé. La seconde voie d'entrée $F_1$, $F_2$... $Fn_{-1}$ du sélecteur de voie $SW_1$, $SW_2$... $SW_{n-1}$ est connectée à la sortie $L_2$, $L_3$... $L_n$ du sélecteur de voie associé au filtre suivant dans la série. L'entrée $F_n$ du sélecteur de voie $SW_n$ est connectée à la sortie de son filtre associé $PB_{1n}$, et la sortie $L_1$ du sélecteur de voie $SW_1$ est connectée à la sortie du filtre numérique adaptatif et correspond au signal de sortie out(t). Chaque sélecteur de voie $SW_1$, $SW_2$... $SW_n$, reçoit un signal de contrôle binaire sur son entrée de commande $J_1$, $J_2$...$J_n$, et selon la valeur du signal de contrôle, il délivre en sortie $L_1$, $L_2$... $L_n$ soit le signal reçu en première voie d'entrée $E_1$, $E_2$... $E_n$, soit le signal reçu en seconde voie d'entrée $F_1$, $F_2$... $F_n$. L'entrée de commande $J_1$, $J_2$...$J_n$, de chaque sélecteur de voie est connectée à la sortie d'un élément comparateur décrit plus loin.

Le filtre dérivateur $D_{21}$ est relié en série avec, dans l'ordre, deux filtres passe-bas $PB_{21}$ et $PB_{22}$, un filtre dérivateur $D_{22}$ et un bloc V qui transforme le signal reçu à son entrée en sa valeur absolue. La sortie du bloc V est connectée aux entrées $A_1$, $A_2$...$A_n$ des éléments comparateurs $C_1$, $C_2$...$C_n$. Chaque entrée $B_1$, $B_2$...$B_n$ des comparateurs $C_1$, $C_2$...$C_n$ reçoit un signal constant et prédéterminé $S_1$, $S_2$... $S_n$. Le signal généré en sortie du comparateur correspond aux deux résultats possibles de la comparaison entre ses deux entrées. La sortie $O_1$ (respectivement $O_2$, $O_3$...$O_n$) du comparateur $C_1$ (respectivement $C_2$, $C_3$...$C_n$) est connectée à l'entrée de commande $J_1$ (respectivement $J_2$, $J_3$...$J_n$) des sélecteurs de voie.

Lorsque le système est en fonctionnement, le signal numérisé d'entrée du filtre adaptatif $in(t)$ est injecté dans le filtre dérivateur $D_{21}$ qui produit la dérivée numérique première du signal, puis $PB_{12}$ et $PB_{22}$ filtrent cette dérivée pour éviter que le bruit de quantification ne brouille trop le signal. $D_{22}$ et V produisent un signal S qui donne le niveau de variation du signal réel et le régime ou l'amplitude balayée par la grandeur mesurée. Cette valeur est ensuite distribuée dans les n lignes parallèles qui mènent chacune à un comparateur associé à un seuil particulier. Tous les comparateurs fonctionnent de manière identique, si $A_k \geq B_k$ la sortie générée en Ok vaut 1, si $A_k < B_k$ la sortie générée en Ok vaut 0.

Les différents seuils prédéterminés avant l'opération de filtrage sont choisis de sorte que $S_1 > S_2 > S_3 > \cdots > Sn$.

Deux seuils consécutifs $S_k > S_{k+1}$ encadrent la valeur V de sorte que :

$$S_k > S \geq S_{k+1}$$

En entrée du comparateur $C_{k+1}$, $A_{k+1} = S \geq B_{k+1} = S_{k+1}$ et le signal délivré en sortie $O_{k+1}$ vaut 1.

C'est le cas aussi pour tous les comparateurs dont le seuil est inférieur à $S_{k+1}$, c'est-à-dire les seuils $S_{k+2}$, $S_{k+3}$ jusqu'à $S_n$.

En entrée du comparateur $C_k$, $A_k = S < B_k = S_k$ et le signal délivré en sortie $O_k$ vaut 0.

C'est le cas aussi pour tous les comparateurs dont le seuil est supérieur à $S_k$, c'est-à-dire les seuils $S_{k-1}$, $S_{k-2}$ jusqu'à $S_1$.

Les comparateurs $C_1$ à $C_n$ délivrent le signal 0 ou 1 à l'entrée de commande des sélecteurs de voie $SW_1$, $SW_2$... $SW_n$.

Tous les sélecteurs de voie fonctionnent de manière identique, le signal délivré en sortie L vaut soit le signal reçu en première voie d'entrée E si le signal de contrôle vaut 1, soit le signal reçu en seconde voie d'entrée F si le signal de contrôle vaut 0.

Les comparateurs $C_1$ à $C_k$ délivrent le signal 0 à l'entrée de commande des sélecteurs de voie $SW_1$, $SW_2$...$SW_k$. Il est donc délivré aux sorties $L_1$ (respectivement $L_2$...$L_k$) les signaux reçus aux secondes voies d'entrée $F_1$ (respectivement $F_2$...$F_k$ ).

Les comparateurs $C_{k+1}$ à $C_n$ délivrent le signal 1 à l'entrée de commande des sélecteurs de voie $SW_{k+1}$, $Sw_{k+2}$...$SW_n$. Il est donc délivré aux sorties $L_{k+1}$ (respectivement $L_{k+2}$...$L_n$) les signaux reçus aux premières voies d'entrée $E_{k+1}$ (respectivement $E_{k+2}$...$E_n$).

Dans ces conditions, le signal en sortie du système $out(t)$ correspond au signal numérisé d'entrée du filtre adaptatif $in(t)$ qui a traversé le filtre dérivateur $D_{11}$ puis le filtre passe-bas $PB_{10}$, puis les filtres contrôlés passe-bas $PB_{11}$, $PB_{12}$... $PB_{1k+1}$ et enfin les sélecteurs de voie $SW_1$, $SW_2$... $SW_{k+1}$.

Le système se comporte donc de la manière suivante : si $S_k > S \geq S_{k+1}$ alors le signal en sortie du système $out(t)$ correspond au signal numérisé d'entrée $in(t)$ du filtre adaptatif qui a traversé k filtres passe-bas.

Dans ces conditions, si S augmente le nombre k diminue et le filtrage diminue, et inversement si S diminue le nombre k augmente et le filtrage augmente.

Le système permet donc d'adapter le nombre de filtres contrôlés passe-bas traversés par la dérivée numérique première en fonction de la valeur S, c'est-à-dire d'adapter l'intensité du filtrage en fonction du niveau de variations du signal réel, c'est-à-dire en fonction de l'amplitude balayée par le signal. En d'autres termes, dans le cas où la grandeur mesurée est représentative d'un régime moteur, l'intensité du filtrage est adaptée en fonction du niveau de variations du régime.

Dans ce système, le signal en sortie du système $out(t)$ correspond au signal numérisé d'entrée $in(t)$ du filtre adaptatif qui a traversé au moins le filtre $PB_{10}$ distinct des filtres contrôlés $PB_{11}$, $PB_{12}$... $PB_{1n}$ de sorte qu'un filtrage fréquentiel du signal d'entrée est réalisé par le filtre $PB_{10}$ quel que soit le résultat des comparaisons au sein des comparateurs $C_1$, $C_2$...$C_n$.

Autrement dit, le signal d'entrée (3b, 4b, 5b) traverse le filtre $PB_{10}$ quelle que soit la valeur du signal S qui donne le niveau de variation du signal réel et le régime ou l'amplitude balayée par la grandeur mesurée.

Le filtre $PB_{10}$ est agencé en amont des filtres contrôlés $PB_{11}$, $PB_{12}$... $PB_{1n}$, mais le filtre $PB_{10}$ peut également être agencé en aval de ces filtres contrôlés, et se situer après la sortie $L_1$ du sélecteur de voie $SW_1$.

Cet exemple particulier de mise en oeuvre de l'invention nécessite des filtres passe-bas qui sont des éléments connus de l'homme du métier, comme des filtres à réponse impulsionnelles finies ou infinies, des moyennes glissantes pondérées, des filtres passe-bas d'ordre 1, d'ordre 2, d'ordre 4, etc... Une moyenne glissante sur 2 pas recevant un signal $U(t)$ en entrée délivre le signal $\dfrac{U(t)+U(t-\Delta t)}{2}$ où $\Delta t$ est le pas d'échantillonnage temporel. Une moyenne glissante sur 4 pas correspond à la formule $\dfrac{U(t)+U(t-\Delta t)+U(t-2\Delta t)+U(t-3\Delta t)}{4}$.

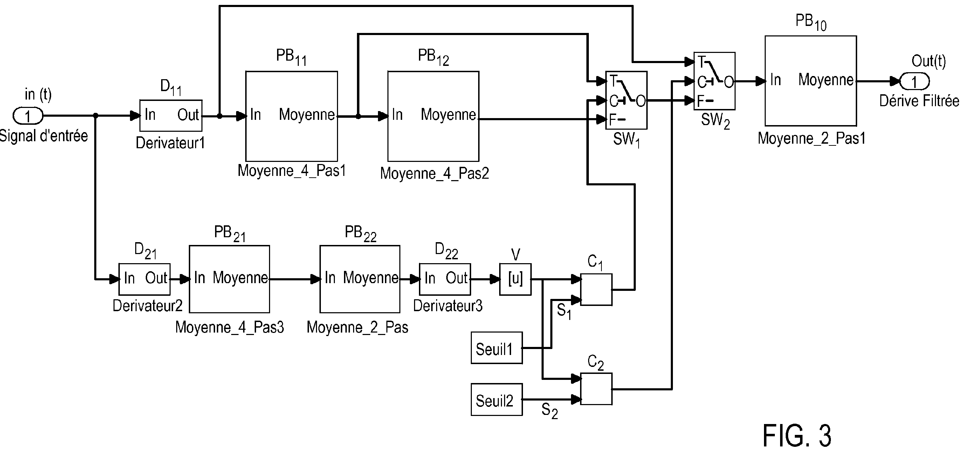

La Figure 3 représente un diagramme fonctionnel de filtre numérique adaptatif selon un exemple particulier de mise en oeuvre de l'invention, correspondant au système représenté dans la figure 2 dans le cas où n=2, avec une seule différence : le filtre passe-bas $PB_{10}$ est placé après la sortie du dernier sélecteur de voie au lieu d'être placé juste après le filtre dérivateur $D_{11}$.

A nouveau le signal en sortie du système $out(t)$ correspond au signal numérisé d'entrée $in(t)$ du filtre adaptatif qui a traversé au moins le filtre $PB_{10}$ distinct

des filtres contrôlés $PB_{11}$ et $PB_{12}$. Le signal d'entrée (3b, 4b, 5b) traverse le filtre $PB_{10}$ quelle que soit la valeur du signal $S$ qui donne le niveau de variation du signal réel et le régime ou l'amplitude balayée par la grandeur mesurée.

Cette fois, le filtre $PB_{10}$ est agencé en aval des filtres contrôlés $PB_{11}$, et $PB_{12}$, mais le filtre $PB_{10}$ peut également être agencé en amont de ces filtres contrôlés, et se situer entre le filtre dérivateur $D_{11}$ et le filtre contrôlé $PB_{11}$.

Le comportement de ce système est exactement celui du système décrit par la Figure 2 dans le cas où n=2 et où :

- $PB_{11}$, $PB_{12}$ et $PB_{21}$ sont des moyennes sur 4 pas
- $PB_{10}$ et $PB_{22}$ sont des moyennes sur 2 pas.

Le système permet donc d'adapter le nombre de filtres traversés (entre 1 et 3) par la dérivée numérique première en fonction de la valeur $S$ comparée à deux seuils, c'est-à-dire d'adapter l'intensité du filtrage en fonction du niveau de variations du signal réel, c'est-à-dire de l'amplitude balayée par le signal représentatif de la grandeur mesurée.

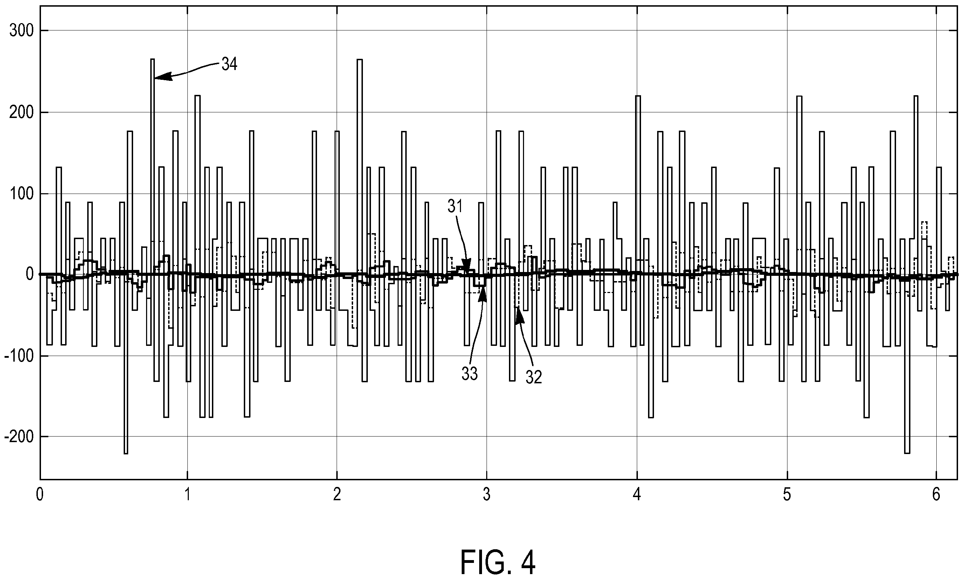

La Figure 4 représente le signal dN2/dt au cours du temps dans le régime stable, au sein d'un système régulé dont le signal de commande fait intervenir le signal dérivé dN2/dt. Les quatre courbes correspondent à quatre situations de filtrage différentes du signal dérivé : dN2/dt est soit filtré par un filtre passe-bas d'ordre 4 (courbe 31), soit filtré par une moyenne sur 4 pas (courbe 32), soit filtré par un filtre numérique adaptatif (courbe 33) selon un exemple particulier de mise en oeuvre de l'invention correspondant au diagramme fonctionnel de la Figure 2, soit non filtré (courbe 34).

Toutes ces courbes sont centrées sur la valeur zéro, car la vitesse angulaire N2 étant constante, la dérivée dN2/dt est de moyenne nulle. La courbe 34 présente le rapport signal sur bruit le plus important, il est dû essentiellement au bruit d'échantillonnage qui n'est pas filtré.

La courbe 31 présente le rapport signal sur bruit le plus faible, elle correspond au filtrage le plus important.

La courbe 32 présente un rapport signal sur bruit située entre ceux des courbes 31 et 34, car elle correspond à un filtrage moins important que le filtre passe-bas d'ordre 4.

Enfin la courbe 33 présente un rapport signal sur bruit située entre ceux des courbes 31 et 32. Cela montre que les performances du filtre numérique adaptatif dans un régime stable sont meilleures que pour une moyenne glissante sur 4 pas mais inférieures à celles d'un filtre passe-bas d'ordre 4.

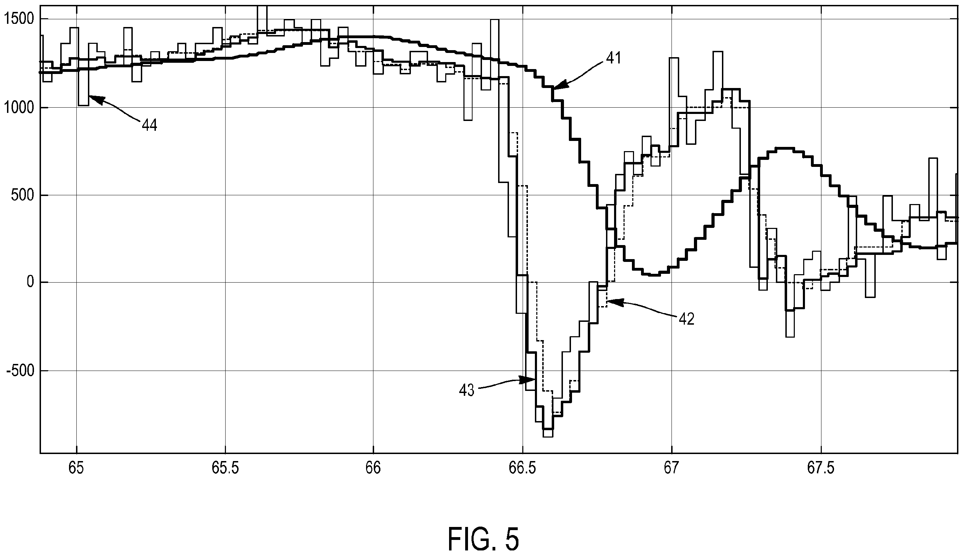

La Figure 5 représente le signal N2 au cours du temps dans un régime de variations rapides, au sein d'un système régulé avec une boucle qui fait intervenir le signal dérivé dN2/dt. Les quatre courbes correspondent aux quatre situations de filtrage précédemment décrites pour la Figure 4 : filtre passe-bas d'ordre 4 (courbe 41), moyenne sur 4 pas (courbe 42), filtre numérique adaptatif (courbe 43) selon un exemple particulier de mise en oeuvre de l'invention correspondant au diagramme fonctionnel de la Figure 2, non filtré (courbe 44).

La courbe 44 présente à nouveau le rapport signal sur bruit le plus important, toujours dû au bruit d'échantillonnage non filtré. Le signal varie de manière importante en passant d'environ 1200 rpm à -600 rpm, puis il réaugmente jusqu'à la valeur 1000 rpm.

La courbe 41 présente le retard le plus important avec le signal non filtré : ce signal diminue bien après que la courbe 44 ait atteint son minimum et même ce signal continue à diminuer alors que la courbe 44 a déjà réaugmenté. De plus, l'amplitude de la variation du signal non filtré n'est pas restituée, le signal 41 passe de 1200 rpm à 0 rpm puis il réaugmente vers 700 rpm.

La courbe 42 présente un retard moins important avec le signal non filtré et restitue mieux l'amplitude de la variation du signal non-filtré

Enfin la courbe 43 présente le retard encore plus faible et restitue encore mieux l'amplitude de la variation du signal non-filtré.

Le filtre numérique adaptatif présente donc des performances meilleures que la moyenne glissante sur 4 points en régime stable comme en régime à variations rapides. Il présente un signal sur bruit favorable pour la régulation et peu de retard sur le signal non filtré en régime à variations rapides.

Ce filtre permet un retard suffisamment faible sur le signal réel et possède un rapport signal sur bruit suffisamment important pour contrôler le système en régime stable comme en régime à variations rapides.

L'invention s'applique à la génération d'un signal de base utilisé dans la régulation d'une turbomachine, en particulier la régulation de la vitesse angulaire d'un arbre moteur du corps basse-pression ou du corps haute-pression d'une turbomachine double corps double flux.

En particulier, le filtre numérique adaptatif est apte à être utilisé pour contrôler la turbomachine en accélération de régime moteur. Dans le cas où la vitesse de l'arbre est numérisée avec un pas d'échantillonnage et un pas de quantification et qu'elle présente un bruit de quantification, le filtre numérique adaptatif permet de gérer la régulation de consignes d'accélération angulaire pouvant avoir des valeurs inférieures au rapport d'un pas de quantification sur un pas d'échantillonnage du signal d'entrée numérisé. Une dérivée numérique de la vitesse angulaire est alors utilisée pour la régulation, cette dérivée peut être généré par un filtre adaptatif tel qu'on l'a présenté plus haut.

Le signal de base peut être généré à partir d'un signal d'entrée relatif à la vitesse angulaire N1 du corps basse-pression ou N2 du corps haute-pression, ou de tout arbre moteur d'une turbomachine en général. Il peut être généré à partir d'un signal de mesure relatif à d'autres grandeurs d'une turbomachine comme par exemple une pression dont la mesure est utilisée dans la régulation de la turbomachine.

L'invention n'est pas limitée aux modes de réalisation décrits et représentés dans les figures annexées. Des modifications restent possibles, notamment du point de vue de la constitution des divers éléments ou par substitution d'équivalents techniques, sans sortir pour autant du domaine de protection de l'invention.

**Revendications**

1. Procédé de filtrage d'un signal d'entrée (3b, 4b, 5b) relatif à une grandeur physique d'une turbomachine (9), le signal d'entrée étant numérisé, le procédé mettant en oeuvre dans un calculateur (6) d'un système de régulation (7) de ladite turbomachine (9) un filtrage fréquentiel dudit signal, ledit signal étant fourni à l'entrée du calculateur, une dérivée numérique dudit signal étant destinée à être utilisée par le système de régulation (7), **caractérisé en ce que** l'on met en oeuvre :

   - une détection sur ledit signal d'entrée d'une variation d'amplitude de ladite grandeur, par une étape de génération d'un signal de dérivée seconde (S) du signal d'entrée et une étape de comparaison d'une valeur du signal de dérivée seconde du signal d'entrée avec au moins un seuil prédéterminé ($S_1$... $S_n$),
   - une adaptation du filtrage fréquentiel dudit signal d'entrée en fonction de la variation d'amplitude détectée de ladite grandeur, par une étape de contrôle d'un filtre contrôlé ($PB_{11}$) apte à appliquer un filtrage fréquentiel de type passe-bas au signal d'entrée, de sorte que le filtre contrôlé applique le filtrage fréquentiel si la valeur du signal de dérivée seconde (S) du signal d'entrée est inférieure à l'au moins un seuil prédéterminé ($S_1$...$S_n$).

2. Procédé selon la revendication 1, **caractérisé en ce que** le signal d'entrée (3b, 4b, 5b) traverse un filtre ($PB_{10}$) distinct du filtre contrôlé ($PB_{11}$) de sorte qu'un filtrage fréquentiel du signal d'entrée est réalisé par le filtre ($PB_{10}$) distinct du filtre contrôlé ($PB_{11}$) quel que soit le résultat de l'étape de comparaison, le filtre ($PB_{10}$) distinct du filtre contrôlé ($PB_{11}$) étant agencé soit en amont soit en aval du filtre contrôlé ($PB_{11}$).

3. Procédé selon la revendication 1 ou 2, comprenant des étapes de :

   - comparaison d'une valeur du signal de dérivée seconde (S) du signal d'entrée avec plusieurs seuils prédéterminés ($S_1$...$S_n$),
   - contrôle de plusieurs filtres contrôlés ($PB_{11}$...$PB_{1n}$), chacun apte à appliquer un filtrage fréquentiel au signal d'entrée, de sorte que le filtre contrôlé applique ou non le filtrage fréquentiel en fonction d'un résultat de la comparaison à un des seuils.

4. Procédé selon la revendication 2 ou 3, dans lequel :

   - chaque filtre contrôlé ($PB_{11}$...$PB_{1n}$) est apte à appliquer un filtrage fréquentiel de type passe-bas, chaque filtre contrôlé étant associé à un seuil prédéterminé ($S_1$... $S_n$);
   - le contrôle d'un filtre contrôlé est configuré de sorte que le filtre contrôlé n'applique pas le filtrage fréquentiel si une valeur du signal de dérivée seconde (S) du signal d'entrée est supérieure à son seuil prédéterminé associé ;

5. Procédé selon la revendication 3 ou 4, comprenant des étapes de :

   - réception par au moins un comparateur ($C_1$...$C_n$) à deux entrées et une sortie, sur une première entrée d'un signal de dérivée seconde (S) du signal d'entrée et sur la seconde entrée d'un signal correspondant à un seuil prédéterminé ($S_1$... $S_n$),
   - génération par au moins un comparateur ($C_1$...$C_n$) d'un signal de comparaison correspondant au résultat de la comparaison entre les signaux reçus sur ses deux entrées,
   - réception par au moins un sélecteur de voie ($SW_1$... $SW_n$) à :

      ○ une première voie d'entrée ($E_1$...$E_n$)
      ○ une seconde voie d'entrée ($F_1$...$F_n$),
      ○ une entrée de commande ($J_1$...$J_n$) et
      ○ une sortie ($L_1$...$L_n$),

   du signal de comparaison sur son entrée de commande ($J_1$...$J_n$), chaque sélecteur de voie étant associé à un filtre contrôlé ($PB_{11}$...$PB_{1n}$) apte à appliquer un filtrage fréquentiel,
   - réception sur une des premières voies d'entrée ($E_1$... $E_n$) d'au moins un sélecteur de voie ($SW_1$... $SW_n$) du signal d'entrée de son filtre contrôlé associé ($PB_{11}$...$PB_{1n}$), et sur sa seconde voie d'entrée ($F_1$... $F_n$) d'un signal auquel son filtre contrôlé associé a appliqué le filtrage fréquentiel,
   - transmission vers la sortie ($L_1$... $L_n$) du sélecteur de voie ($SW_1$...$SW_n$) de l'un de ses deux signaux selon la valeur du signal de comparaison.

6. Procédé selon la revendication 5, dans lequel l'étape de génération d'un signal de dérivée seconde (S) du signal d'entrée comprend les étapes suivantes :

   - génération d'un signal de dérivée première du signal d'entrée par application d'un filtre dérivateur ($D_{21}$) au signal d'entrée,

- génération d'un signal de dérivée première filtré par application d'au moins un filtre fréquentiel de type « passe-bas » ($PB_{21}$, $PB_{22}$) à un signal de dérivée première,

- génération d'un signal de dérivée seconde par application d'un filtre dérivateur ($D_{22}$) à un signal de dérivée première filtré.

7. Procédé selon la revendication 5 ou 6, dans lequel au moins un filtre de type « passe-bas » correspond à une moyenne sur plusieurs pas.

8. Procédé selon l'une des revendications précédentes, dans lequel la grandeur physique de la turbomachine (9) est la vitesse angulaire d'un arbre moteur de la turbomachine (9).

9. Calculateur (6) d'un système de régulation de la vitesse angulaire d'un arbre moteur de la turbomachine (9), **caractérisé en ce qu'**il est configuré pour mettre en oeuvre un procédé selon l'une des revendications précédentes, ledit calculateur recevant en entrée un signal d'entrée relatif à une grandeur de la turbomachine et générant en sortie un signal de base utilisé dans la régulation de la vitesse angulaire de l'arbre moteur.

10. Ensemble comportant une turbomachine (9) comprenant au moins un arbre moteur et un système de régulation de la vitesse angulaire d'un arbre moteur de la turbomachine (9), **caractérisé en ce que** le système de régulation comporte un calculateur selon la revendication 9, ledit calculateur recevant en entrée un signal d'entrée relatif à une grandeur de la turbomachine et générant en sortie un signal de base utilisé dans la régulation de la vitesse angulaire de l'arbre, le système de régulation commandant la turbomachine en fonction du signal de mesure (8) filtré ainsi généré par ledit calculateur.

11. Ensemble selon la revendication précédente, dans lequel une dérivée numérique de la vitesse angulaire dudit arbre moteur est utilisée par le système de régulation (7) pour contrôler la turbomachine (9) en accélération de régime moteur, et dans lequel le système de régulation (7) est prévu pour fournir des consignes d'accélération angulaire pouvant avoir des valeurs inférieures au rapport d'un pas de quantification sur un pas d'échantillonnage du signal d'entrée numérisé, le signal d'entrée étant une mesure de la vitesse angulaire.

12. Programme d'ordinateur comprenant des instructions adaptées à la mise en oeuvre de chacune de chacune des étapes du procédé selon l'une quelconque des revendications 1 à 8 lorsque ledit programme est exécuté sur un ordinateur.

**Patentansprüche**

1. Verfahren zum Filtern eines Eingangssignals (3b, 4b, 5b) in Bezug auf eine physikalische Größe einer Strömungsmaschine (9), wobei das Eingangssignal digitalisiert ist, wobei das Verfahren in einem Computer (6) eines Regelsystems (7) der Strömungsmaschine (9) eine Frequenzfilterung des Signals durchführt, wobei eine digitale Ableitung des Signals dazu bestimmt ist, von dem Regelsystem (7) verwendet zu werden,

**dadurch gekennzeichnet, dass** es Folgendes durchführt:

- Erfassen einer Amplitudenänderung der Größe an dem Eingangssignal durch einen Schritt des Erzeugens eines zweiten Ableitungssignals (S) des Eingangssignals und einen Schritt des Vergleichens einer Größe des zweiten Ableitungssignals des Eingangssignals mit mindestens einem vorbestimmten Schwellenwert (S1...Sn),

- Anpassen der Frequenzfilterung des Eingangssignals in Abhängigkeit von der erfassten Amplitudenänderung der Größe durch einen Schritt des Steuerns eines gesteuerten Filters ($PB_{11}$), das ausgelegt ist, eine Frequenzfilterung vom Tiefpass-Typ am Eingangssignal anzuwenden, so dass das gesteuerte Filter die Frequenzfilterung anwendet, wenn der Wert des zweiten Ableitungssignals (S) des Eingangssignals kleiner ist als der mindestens eine vorbestimmte Schwellenwert ($S_1...S_n$).

2. Verfahren nach Anspruch 1, **dadurch gekennzeichnet, dass** das Eingangssignal (3b, 4b, 5b) ein von dem gesteuerten Filter ($PB_{11}$) getrenntes Filter ($PB_{10}$) durchläuft, so dass eine Frequenzfilterung des Eingangssignals durch das von dem gesteuerten Filter ($PB_{11}$) getrennte Filter ($PB_{10}$) unabhängig von dem Ergebnis des Schritts des Vergleichens ausgeführt wird, wobei das von dem gesteuerten Filter ($PB_{11}$) getrennte Filter ($PB_{10}$) entweder stromaufwärts oder stromabwärts des gesteuerten Filters ($FB_{11}$) angeordnet ist.

3. Verfahren nach Anspruch 1 oder 2, umfassend die folgenden Schritte:

- Vergleichen eines Werts des zweiten Ableitungssignals (S) des Eingangssignals mit mehreren vorbestimmten Schwellenwerten ($S_1...S_n$),

- Steuern von mehreren gesteuerten Filtern ($PB_{11}... PB_{1n}$), die jeweils ausgelegt sind, um eine Frequenzfilterung an einem Eingangssignal anzuwenden, so dass das gesteuerte Filter die Frequenzfilterung in Abhängigkeit von einem Ergebnis des Vergleichens mit einem der Schwellenwerte anwendet oder nicht.

4. Verfahren nach Anspruch 2 oder 3, wobei:

- jedes gesteuerte Filter ($PB_{11}$... $PB_{1n}$) ausgelegt ist, eine Frequenzfilterung vom Tiefpass-Typ anzuwenden, wobei jedes gesteuerte Filter einem vorbestimmten Schwellenwert ($S_1$... $S_n$) zugeordnet ist;
- das Steuern eines gesteuerten Filters so konfiguriert ist, dass das gesteuerte Filter die Frequenzfilterung nicht anwendet, wenn ein Wert des zweiten Ableitungssignals (S) des Eingangssignals größer ist als sein zugeordneter vorbestimmter Schwellenwert.

5. Verfahren nach Anspruch 3 oder 4, umfassend die folgenden Schritte:

- Empfangen, durch mindestens einen Komparator ($C_1$... $C_n$) mit zwei Eingängen und einen Ausgang, an einem ersten Eingang eines zweiten Ableitungssignals (S) des Eingangssignals und an dem zweiten Eingang eines Signals, das einem vorbestimmten Schwellenwert ($S_1$... $S_n$) entspricht,
- Erzeugen, durch mindestens einen Komparator ($C_1$...$C_n$), eines Vergleichssignals, das dem Ergebnis des Vergleichs zwischen den auf seinen zwei Eingängen empfangenen Signalen entspricht,
- Empfangen durch mindestens einen Pfadwähler ($SW_1$... $SW_n$) auf:

  ◦ einem ersten Eingangspfad ($E_1$... $E_n$),
  ◦ einem zweiten Eingangspfad ($F_1$... $F_n$)
  ◦ einem Befehlseingang ($J_1$... $J_n$) und
  ◦ einem Ausgang ($L_1$... $L_n$),

des Vergleichssignals an seinem Befehlseingang ($J_1$... $J_n$), wobei jeder Pfadwähler einem gesteuerten Filter ($PB_{11}$... $PB_{1n}$) zugeordnet ist, das ausgelegt ist, eine Frequenzfilterung anzuwenden,
- Empfangen des Eingangssignals des ihm zugeordneten gesteuerten Filters ($PB_{11}$... $PB_{1n}$) auf einem der ersten Eingangspfade ($E_1$... $E_n$) mindestens eines Pfadwählers ($SW_1$... $SW_n$) und eines Signals, auf das das ihm zugeordnete gesteuerte Filter die Frequenzfilterung angewendet hat, auf seinem zweiten Eingangskanal ($F_1$... $F_n$),
- Übertragen eines seiner beiden Signale zum Ausgang ($L_1$... $L_n$) des Pfadwählers ($SW_1$...

$SW_n$) gemäß dem Wert des Vergleichssignals.

6. Verfahren nach Anspruch 5, wobei der Schritt des Erzeugens eines zweiten Ableitungssignals (S) des Eingangssignals die folgenden Schritte umfasst:

- Erzeugen eines ersten Ableitungssignals des Eingangssignals durch Anwendung eines Ableitungsfilters ($D_{21}$) auf das Eingangssignal,
- Erzeugen eines gefilterten ersten Ableitungssignals durch Anwendung mindestens einer Frequenzfilterung vom Tiefpass-Typ ($PB_{21}$, $PB_{22}$) auf ein erstes Ableitungssignal,
- Erzeugen eines zweiten Ableitungssignals durch Anwendung eines Ableitungsfilters ($D_{22}$) auf ein gefiltertes erstes Ableitungssignal.

7. Verfahren nach Anspruch 5 oder 6, wobei mindestens ein Filter vom Tiefpass-Typ einem Mittelwert über mehrere Schritte entspricht.

8. Verfahren nach einem der vorhergehenden Ansprüche, wobei die physikalische Größe der Strömungsmaschine (9) die Winkelgeschwindigkeit einer Motorwelle der Strömungsmaschine (9) ist.

9. Computer (6) eines Regelsystems für die Winkelgeschwindigkeit einer Motorwelle der Strömungsmaschine (9), **dadurch gekennzeichnet, dass** er konfiguriert ist, um ein Verfahren nach einem der vorhergehenden Ansprüche durchzuführen, wobei der Computer am Eingang ein Eingangssignal empfängt, das sich auf eine Größe der Strömungsmaschine bezieht, und am Ausgang ein Basissignal erzeugt, das bei der Regelung der Winkelgeschwindigkeit der Motorwelle verwendet wird.

10. Anordnung, aufweisend eine Strömungsmaschine (9), die mindestens eine Motorwelle und ein Regelsystem für die Winkelgeschwindigkeit einer Motorwelle der Strömungsmaschine (9) umfasst, **dadurch gekennzeichnet, dass** das Regelsystem einen Computer nach Anspruch 9 umfasst, wobei der Computer am Eingang ein Eingangssignal empfängt, das sich auf eine Größe der Strömungsmaschine bezieht, und am Ausgang ein Basissignal erzeugt, das bei der Regelung der Winkelgeschwindigkeit der Welle verwendet wird, wobei das Regelsystem die Strömungsmaschine in Abhängigkeit von dem so von dem Computer erzeugten gefilterten Messsignal (8) steuert.

11. Anordnung nach dem vorhergehenden Anspruch, wobei eine numerische Ableitung der Winkelgeschwindigkeit der Motorwelle von dem Regelsystem (7) verwendet wird, um die Strömungsmaschine (9) beim Beschleunigen der Motordrehzahl zu steuern, und wobei das Regelsystem (7) dazu vorgesehen ist, Winkelbeschleunigungsbefehle bereitzustellen, die Werte haben können, die kleiner sind als das Verhältnis eines Quantisierungsschritts zu einem Abtastschritt des digitalisierten Eingangssignals, wobei das Eingangssignal eine Messung der Winkelgeschwindigkeit ist.

12. Computerprogramm, das Anweisungen umfasst, die dazu ausgelegt sind, jeden einzelnen der Schritte des Verfahrens nach einem der Ansprüche 1 bis 8 durchzuführen, wenn das Programm auf einem Computer ausgeführt wird.

**Claims**

1. Method of filtering an input signal (3b, 4b, 5b) relating to a physical quantity of a turbomachine (9), the input signal being digitized, the method implementing in a computer (6) of a control system (7) of the said turbomachine (9) a frequency filtering of the said signal, the said signal being supplied at the input of the computer, a digital derivative of the said signal being intended to be used by the control system (7) **characterized in that** the following is implemented:

   - a detection in said input signal of a variation in amplitude of said quantity, by a step of generating a second derivative signal (S) of the input signal and a step of comparing a value of the second derivative signal of the input signal with at least one predetermined threshold (S1...Sn),
   - adapting the frequency filtering of said input signal as a function of the detected amplitude variation of said quantity, by a step of controlling a controlled filter (PB11) configured to apply a low-pass type frequency filtering to the input signal, so that the controlled filter applies the frequency filtering if the value of the second derivative signal (S) of the input signal is lower than the at least one predetermined threshold (S1 ...Sn).

2. Method according to claim 1, **characterized in that** the input signal (3b, 4b, 5b) passes through a filter (PB10) distinct from the controlled filter (PB11) so that frequency filtering of the input signal is performed by the filter (PB10) distinct from the controlled filter (PB11) regardless of the result of the comparison step, the filter (PB10) distinct from the controlled filter (PB11) being arranged either upstream or downstream of the controlled filter (PB11).

3. Method according to claim 1 or 2, comprising the steps of:

   - comparing a value of the second derivative signal (S) of the input signal with several predetermined thresholds (S1...Sn),
   - controlling a plurality of controlled filters (PB11...PB1n), each configured to apply frequency filtering to the input signal, such that the controlled filter applies or does not apply the frequency filtering depending on a result of the comparison to one of the thresholds.

4. Method according to claim 2 or 3, wherein:

   - each controlled filter (PB11...PB1n) is configured to apply low-pass frequency filtering, each controlled filter being associated with a predetermined threshold (S1...Sn);
   - the control of a controlled filter is configured so that the controlled filter does not apply the frequency filtering if a value of the second derivative signal (S) of the input signal is higher than its associated predetermined threshold;

5. Method according to claim 3 or 4, comprising the steps of:

   - receiving by at least one comparator (C1...Cn) with two inputs and one output, on a first input a second derivative signal (S) of the input signal and on the second input a signal corresponding to a predetermined threshold (S1...Sn),
   - generation by at least one comparator (C1...Cn) of a comparison signal corresponding to the result of the comparison between the signals received on its two inputs
   - reception by at least one channel selector (SW1 ...SWn) at:

     o a first input channel (E1...En)
     o a second input channel (F1 ...Fn),
     o a control input (J1...Jn) and
     o an output (L1...Ln),

   of the comparison signal on its control input (J1...Jn), each channel selector being associated with a controlled filter (PB11...PB1n) configured to apply a frequency filtering,
   - reception on one of the first input channels (E1...En) of at least one channel selector (SW1...SWn) of the input signal of its associated controlled filter (PB11...PB1n), and on its second input channel (F1 ...Fn) of a signal to which its associated controlled filter has applied the frequency filtering
   - transmission to the output (L1 ...Ln) of the channel selector (SW1 ...SWn) of one of its two signals depending on the value of the comparison signal.

6. Method according to claim 5, wherein the step of generating a second derivative signal (S) of the input signal comprises the following steps:

- generating a first derivative signal of the input signal by applying a derivative filter (D21) to the input signal,
- generating a filtered first derivative signal by applying at least one low-pass frequency filter (PB21, PB22) to the first derivative signal
- generating a second derivative signal by applying a derivative filter (D22) to a filtered first derivative signal.

7. Method according to claim 5 or 6, wherein at least one low pass filter corresponds to a multi-step average.

8. Method according to any of the preceding claims, wherein the physical quantity of the turbomachine (9) is the angular velocity of a drive shaft of the turbomachine (9).

9. A computer (6) of a system for regulating the angular velocity of a drive shaft of the turbomachine (9), **characterized in that** it is configured to implement a method according to one of the preceding claims, said computer receiving as input an input signal relating to a magnitude of the turbomachine and generating as output a base signal used in the regulation of the angular velocity of the drive shaft.

10. Assembly comprising a turbomachine (9) comprising at least one drive shaft and a system for regulating the angular velocity of a drive shaft of the turbomachine (9), **characterized in that** the regulation system comprises a computer according to claim 9, the said computer receiving at its input an input signal relating to a magnitude of the turbomachine and generating at its output a basic signal used in the regulation of the angular velocity of the shaft, the regulation system controlling the turbomachine as a function of the filtered measurement signal (8) thus generated by the said computer.

11. An assembly according to the preceding claim, wherein a digital derivative of the angular velocity of said engine shaft is used by the control system (7) to control the turbomachine (9) in engine speed acceleration, and wherein the control system (7) is arranged to provide angular acceleration set points which may have values less than the ratio of a quantization step to a sampling step of the digitized input signal, the input signal being a measure of the angular velocity.

12. A computer program comprising instructions adapted to implement each of each of the steps of the method of any one of claims 1 to 8 when said program is executed on a computer.

FIG. 1

FIG. 2

FIG. 3

FIG. 4

FIG. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014053752 A